# EUROPÄISCHE PATENTSCHRIFT

(11) **EP 0 915 794 B1**
(45) Veröffentlichungstag und Bekanntmachung des Hinweises auf die Patenterteilung: **17.05.2000**
(21) Anmeldenummer: 97936684.6
(22) Anmeldetag: 05.08.1997
(51) Int. Cl.: B61D 27/00, B61C 17/04, B61C 3/00

(54) **AUSSENDRUCKUNABHÄNGIGE DROSSELBELÜFTUNG IN SCHIENENFAHRZEUGEN**
EXTERNAL PRESSURE-INDEPENDENT THROTTLE VENTILATION IN RAIL VEHICLES
VENTILATION A ETRANGLEMENT INDEPENDANTE DE LA PRESSION EXTERIEURE DANS DES VEHICULES SUR RAILS

(30) Priorität: 08.08.1996 DE 19632053
(43) Veröffentlichungstag der Anmeldung: 19.05.1999
(73) Patentinhaber: Voith Turbo GmbH & Co. KG, 89522 Heidenheim (DE)
(72) Erfinder: SCHMID, Roland, D-89551 Königsbronn (DE)
(74) Vertreter: Dr. Weitzel & Partner
(86) Internationale Anmeldenummer: EP9704262
(87) Internationale Veröffentlichungsnummer: WO9806616

(56) Entgegenhaltungen:
- DE-U- 8 311 500
- FR-A- 2 703 967

## Beschreibung

Die vorliegende Erfindung betrifft eine Unterflurkühlanlage zur Kühlung von Leistungsbauteilen, die im Unterflurbereich eines Schienenfahrzeuges angeordnet sind sowie ein Verfahren zur Kühlung eines im Unterflurbereich angeordneten elektrischen Leistungsbauteiles.

Betreffend den Stand der Technik wird verwiesen auf
DE-U-83 11 500.5
FR-A-2 703 967

Die FR-A-2 703 967 zeigt eine im Bereich des Daches eines Schienenfahrzeuges angeordnete Kühlanlage, die DE-U-83 11 500.5 ein System zur Belüftung der im Maschinenraum eines elektrischen Schienenfahrzeuges untergebrachten staubempfindlichen Hilfsbetriebseinrichtungen und/oder -geräte.

Bei der Entwicklung neuer Schienenfahrzeuge wird angestrebt, anstelle der bislang bei Hochgeschwindigkeitszügen, wie beispielsweise dem ICE der Deutschen Bundesbahn, verwendeten Hochleistungstriebköpfen Antriebsanlagen zu verwenden, die unterhalb des Wagenbodens angeordnet sind. Hierdurch ergibt sich eine höhere Ausnutzung des Raumes. Bei derartigen Fahrzeugen stellt sich das Problem der Kühlung der im Unterflurbereich angeordneten Leistungselektronikbauteile, beispielsweise das der Kühlung der elektrischen Leistungsdrosseln, die bei Stromrichtern oder auch Transformatoren Verwendung finden.

Aus Gründen der Bauraumausnutzung ist es wünschenswert, daß die elektrischen Leistungsdrosseln in die zur Stromrichter- oder auch Transformatorkühlung benötigten Kühlanlagen eingebaut werden können.

Hierbei stellt sich das Problem einer ausreichenden Kühlung dieser elektrischen Leistungsbauteile, insbesondere soll eine Kühlung auch bei ungünstigen Umströmungsbedingungen und Druckverhältnissen an der Außenhaut des Fahrzeuges und unter dem Fahrzeug gewährleistet werden. Des weiteren soll die Kühlung möglichst energiesparend erfolgen.

Aufgabe der Erfindung ist es somit, eine Kühlanlage zur Verfügung zu stellen, die eine ausreichende Kühlleistung zur Kühlung der im Unterflurbereich angeordneten elektrischen Bauelemente und auch der elektrischen Leistungsdrosseln bei minimalem Energieeinsatz zur Verfügung stellt.

Diese Aufgabe kann in einer ersten Ausführungsform der Erfindung dadurch gelöst werden, daß im Unterflurbereich eine Kühlanlage vorgesehen ist, die mindestens einen Kühllufteinlaß in einer Seitenwand des Fahrzeuges im Unterflurbereich vorsieht, über den Luft in den Unterflurbereich eintreten kann. Diese Luft kann optional über eine erste Flüssigkeitskühleinrichtung für die elektronischen Leistungsbauteile, beispielsweise einen Wasser- oder Ölkühler, geführt und dabei bereits aufgewärmt werden. Mit Hilfe eines Ventilators wird aus dem in den Unterflurbereich eintretenden Hauptluftstrom ein Kühlluftteilstrom zur weiteren Kühlung in Richtung der elektrischen Leistungsbauteile, insbesondere der elektrischen Leistungsdrosseln gefördert. Ein Restluftstrom wird über einen Restluftstromauslaß, der im Fahrzeugboden vorgesehen ist, in Richtung des Gleiskörpers nach unten weggeführt. Der Kühlluftteilstrom wiederum durchströmt das elektrische Leistungsbauteil und kann in einer einfachen Ausführungsart auf der anderen Seite des elektrischen Leistungsbauteiles über einen in die Seitenwand des Fahrzeuges eingelassene Auslaßöffnung austreten. Um sicherzustellen, daß der Kühlluftteilstrom die zu kühlenden Bauelemente erreicht, muß der Kühllluftreststrom nach dem Kühlerventilator gedrosselt werden, so daß sich ein Differenzdruck , beispielsweise von Δp=200 Pa, aufbaut, der dazu führt, daß der Kühlluftteilstrom in Richtung der Auslaßöffnung gefördert wird und dadurch das elektronische Leistungsbauteil kühlt. Besonders vorteilhaft in Bezug auf den Energieverbrauch ist es, wenn der Kühlerventilator in seiner Leistung gerade so dimensioniert ist, daß der für die Kühlung des Leistungsbauteiles unbedingt notwendige Kühlluftteilstrom für die zu kühlenden Bauelemente bereitgestellt wird. Eine derartige Dimensionierung ist deswegen erforderlich, weil der Kühlluftteilstrom gegen den Strömungswiderstand des elektrischen Bauteiles gefördert werden muß. Insbesondere bei hohen Fahrgeschwindigkeiten und Seitenwind können jedoch seitlich und unter dem Fahrzeug ungünstige Druckverhältnisse auftreten. Bei diesen Bedingungen ergibt sich als weiteres Problem der zuvor vorgeschlagenen Unterflurkühlanlage, daß eine nur unzureichende Kühlung gewährleistet wird. Die zuvor genannten Probleme werden durch eine Unterflurkühlanlage gemäß Anspruch 1 und die in den Ansprüchen 7 oder 8 angegebene Verfahren gelöst.

Gemäß Anspruch 1 ist vorgesehen, anstelle der Abführung des erwärmten Kühlluftteilstromes durch eine gegenüber der Einlaßöffnung im Seitenwandbereich des Fahrzeuges angeordnete Auslaßöffnung diese über einen Luftkanal in einen Raum, der in Strömungsrichtung des Hauptluftstromes vor dem Ventilator liegt zurückzuführen. Da vor dem Ventilator ein Unterdruck herrscht, wird durch eine derartige Rückführung der erwärmten Teilkühlluft eine Zwangsdurchströmung des Raumes, in dem die elektrischen Leistungsbauteile angeordnet sind, erzwungen und auf diese Art und Weise völlig unabhängig von Druckverhältnissen, die im Außenbereich des Fahrzeuges herrschen, ständig eine ausreichende Kühlung gewährleistet. Eine derartige Kühlanlage ist somit außendruckunabhängig.

Um zu verhindern, daß die rückgeführte erwärmte Teilkühlluft in Richtung der zu kühlenden Bauelemente gefördert wird und somit die Kühlleistung herabgesetzt wird, ist vorgesehen, die Austrittsöffnung des Luftkanales bzw. dessen austrittsseitiges Ende derart anzuordnen, daß die hieraus austretende, erwärmte Luft z. B. mit Hilfe von Leitblechen so strömungsmäßig umgelenkt werden kann, daß sie nicht mehr erneut zur Kühlung der Leistungsbauelemente herangezogen wird.

Um sicherzustellen, daß bei Kühlanlagen mit mehreren Ventilatoren und infolgedessen mehreren Luftkanälen auch ein Notbetrieb mit nur einem Ventilator möglich ist, schlägt die Erfindung in einer Weiterbildung vor, die einzelnen Luftkanäle mit Abschottungen oder Klappen zu versehen, so daß bei Ausfall eines Ventilators Luftkanäle gesperrt werden können. Durch eine derartige Ausführungsform wird eine ausreichende Kühlung der elektronischen Leistungsbauteile auch im Notbetrieb sichergestellt, insbesondere wird hierdurch eine gleichmäßige Beaufschlagung des Kühlers auch in diesen Betriebssituationen erreicht.

Neben der Vorrichtung schlägt die Erfindung auch ein Verfahren zur Kühlung eines elektrischen Leistungsbauteiles, das im Unterflurbereich eines Schienenfahrzeuges angeordnet ist, vor. Dieses Verfahren zeichnet sich insbesondere dadurch aus, daß Umgebungsluft in den Unterflurbereich gefördert wird. Aus der eingeströmte Umgebungsluft wird mit Hilfe des Ventilators zumindest ein Kühlluftteilstrom des eingeströmten Luftstromes in Richtung der zu kühlenden Bauteile gefördert. Besonders energiesparend ist es, wenn der Ventilator, der den Kühlluftteilstrom in Richtung der zu kühlenden Bauteile fördert, so dimensioniert ist, daß aus dem gesamten in den Unterflurbereich einströmenden Luftstrom der durch das zu kühlende Bauteil geförderte Kühlluftteilstrom gerade die vom elektronischen Bauteil erzeugte Wärme abführen kann, ohne daß es zu einer Überhitzung desselben unter den vorgegebenen Umgebungstemperaturen kommt.

In einer zweiten Ausführungsform ist vorgesehen, daß, nachdem die Leistungsbauteile mittels des in diesem Bereich eintretenden Kühlluftteilstromes gekühlt worden sind, der durch die elektrischen Leistungsbauteile erwärmte Kühlluftteilstrom über einen Luftkanal in einen Raum vor dem Ventilator abgezogen wird. Dieses Abziehen erfolgt als Zwangsströmung durch den Luftkanal aufgrund des Unterdruckes der vor dem Kühlerventilator herrscht. Es besteht somit eine Druckdifferenz zwischen dem Raum, der vor dem Ventilator liegt und dem Raum, der hinter dem Ventilator liegt. Der erwärmte, in den Raum vor dem Ventilator geförderte Kühlluftteilstrom wird über den Ventilator in die Umgebung abgegeben.

Hierdurch wird verhindert, daß es zu einer unerwünschten Mehrfachumwälzung des Kühlluftteilstromes und daraus resultierenden zu einer unzulässigen Temperaturerhöhung des elektronischen Leistungsbauteiles kommt.

Des weiteren kann eine Kühleinrichtung für die elektronischen Leistungsbauteile vorgesehen sein, über die die angesaugte Umgebungsluft geführt wird sowie ein Schwerkraftfilter mit dem die Luft vor Eintritt in die Kühlvorrichtung von Staub und sonstigen Partikeln gereinigt wird. Die die Partikel enthaltende Staubluft tritt ebenfalls durch den Ventilator und den nachgeschalteten Luftauslaß in Richtung des Gleiskörpers aus dem Unterflurbereich des Fahrzeuges aus.

Die vorliegende Erfindung soll nunmehr anhand der Figuren beispielhaft beschrieben werden.

Es zeigen
Fig. 1 einen Querschnitt durch ein Schienenfahrzeug mit im Unterflurbereich angeordneter Kühlanlage zur Kühlung eines elektrischen Leistungsbauteiles,
Fig. 2 eine Unterflurkühlanlage, wobei eine Rückführung des Kühlluftteilstromes in dem Bereich zwischen Kühlvorrichtung und Ventilator nicht vorgesehen ist und
Fig. 3 eine Unterflurkühlanlage mit Luftkanal zur Rückführung des erwärmten Kühlluftteilstromes, die eine außendruckunabhängige Kühlung von elektronischen Leistungsbauteilen ermöglicht.

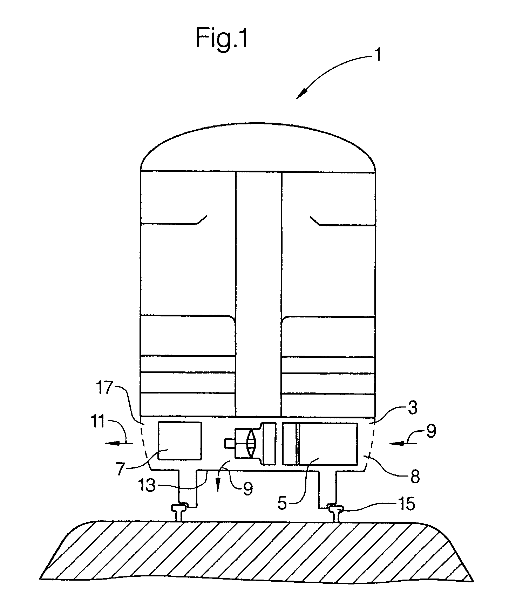

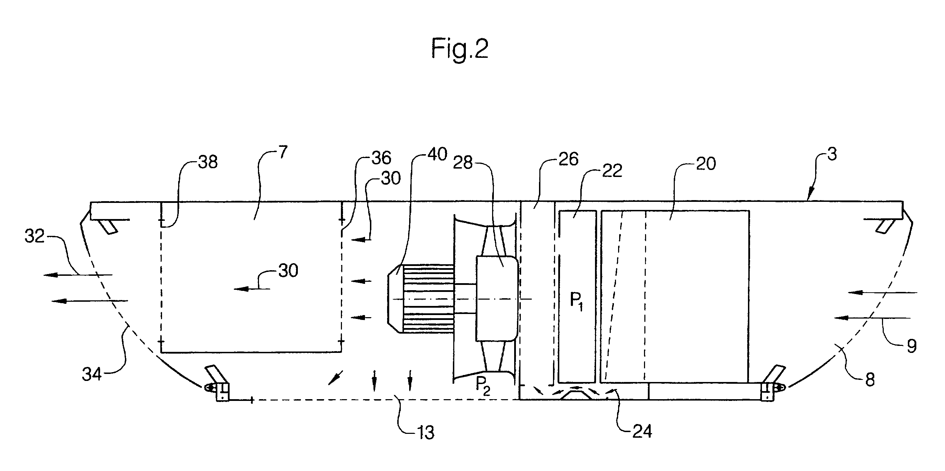

Fig. 1 zeigt ein Schienenfahrzeug 1 im Querschnitt mit einer im Unterflurbereich 3 angeordneten Kühlanlage 5, die sich aus mehreren Bauteilen, wie unter Fig. 2 beschrieben, zusammensetzt. Die elektronischen Leistungsbauteile 7 sind gegenüber der Kühlanlage 5 ebenfalls im Unterflurbereich 3 angeordnet. In den Seitenwänden des Schienenfahrzeuges 1 ist im Unterflurbereich 3 ein Kühleinlaß 8 vorgesehen, über den aus der Umgebung Luft, wie durch Pfeil 9 dargestellt, in den Unterflurbereich einströmen kann. Diese Luft wird durch die Kühlanlage 5 , die beispielsweise auch ein Öl- oder Luftkühler für das elektrische Leistungsbauteil umfassen kann, erwärmt. Der in der Kühlanlage bereits erwärmte Luftstrom 9 teilt sich innerhalb des Unterflurbereiches nach der Kühlanlage 5 in einen Restluftstrom 9 und einen Kühlluftteilstrom 11, der zur weiteren Kühlung des elektrischen Bauelementes 7 verwendet wird, auf. Bei der Kühlung der elektrischen Bauteile mittels des Kühlluftteilstromes 11 wird dieser weiter erwärmt. Der Restluftstrom 9 wird über eine Luftauslaßöffnung 13 im Boden des Fahrzeuges in Richtung des Gleiskörpers 15 abgeführt. Der Kühlluftteilstrom 11 wird nach weiterer Wärmeaufnahme in dem vorliegenden Beispiel über eine in der Fahrzeugseitenwand angeordnete Kühlluftauslaßöffnung 17 abgeführt.

In Fig. 2 ist der Unterflurbereich 3 des Schienenfahrzeuges nochmals näher dargestellt. Wiederum gelangt ein Umgebungsluftstrom 9 über eine in die Seitenwand des Fahrzeuges im Unterflurbereich vorgesehene Kühleinlaßöffnung bzw. Kühleinlaß in den Unterflurbereich des Fahrzeuges. Die Abscheidung von Schmutzpartikeln, die sich in der Umgebungsluft befinden, findet in dem Schwerkraftfilter 20 statt. Es ergibt sich hinter dem Schwerkraftfilter 20 ein relativ sauberer Hauptluftstrom, der über die Flüssigkeitskühlvorrichtung 22 für die elektronischen Leistungsbauteile, beispielsweise einen Öl- oder Wasserkühler geführt und hierbei erwärmt wird und ein nicht erwärmter Staubluftstrom 24, der vorzugsweise direkt hinter dem Kühler 28 über den Luftauslaß 13 in Richtung des Gleiskörpers geführt wird.

Die gereinigte und erwärmte Luft gelangt in einen Raum 26 zwischen Kühlvorrichtung 22 und Ventilator 28, in dem ein Druck P1 herrscht. Durch geeignete Dimensionierung des Ventilators kann man erreichen, daß nur ein Kühlluftteilstrom 30 des Hauptluftstromes durch das zu kühlende Leistungsbauteil 7, das vorzugsweise eine elektrische Leistungsdrossel eines Stromrichters sein kann, gefördert wird. Unmittelbar vor dem Ventilator 28 herrscht ein Druck P1, der stets kleiner ist als P2; es herrscht also ein Unterdruck eingangsseitig am Ventilator. Der für die Kühlung nicht erforderliche Teil des Hauptluftstromes wird als Restluftstrom über den Luftauslaß 13 in Richtung des Gleiskörpers in die Umgebung abgeführt, wobei ein Strömungswiderstand aufgebaut werden muß, der dem des elektrischen Bauteiles 7 und dem Austritt 34 entspricht. Die Aufteilung des Hauptluftstromes ist darauf zurückzuführen, daß das elektrische Leistungsbauteil 7 einen Strömungswiderstand darstellt, der bei entsprechender Dimensionierung des Ventilators nicht vom gesamten Hauptluftstrom, sondern nur von dem zuvor erwähnten Kühlluftteilstrom überwunden werden kann. Hieraus ist ersichtlich, daß mit dieser Anordnung insoweit Energieeinsparpotentiale verbunden sind, als der Ventilator gerade immer so ausgelegt werden kann, daß nur die zur Kühlung erforderliche Luftmenge durch das elektrische Leistungsbauteil gefördert wird. In einer besonders bevorzugten Ausführungsform beträgt der zur Kühlung notwendige Kühlluftteilstrom nur 20 - 30 % des Hauptluftstromes. Der die zu kühlenden Leistungsbauteile 7 durchströmende Teilstrom nimmt die Wärme von den Leistungsbauteilen auf. In dem Ausführungsbeispiel gemäß Fig. 2 wird der durch die Leistungsbauteile 7 weiter erwärmte Kühlluftteilstrom 32 über eine seitlich in der Fahrzeugwand eingebrachte Auslaßöffnung 34 abgeführt.

Trotz dieser Maßnahme ist die Abfuhr der erwärmten Luft bei der Anordnung gemäß Fig. 2 oftmals nicht ausreichend.

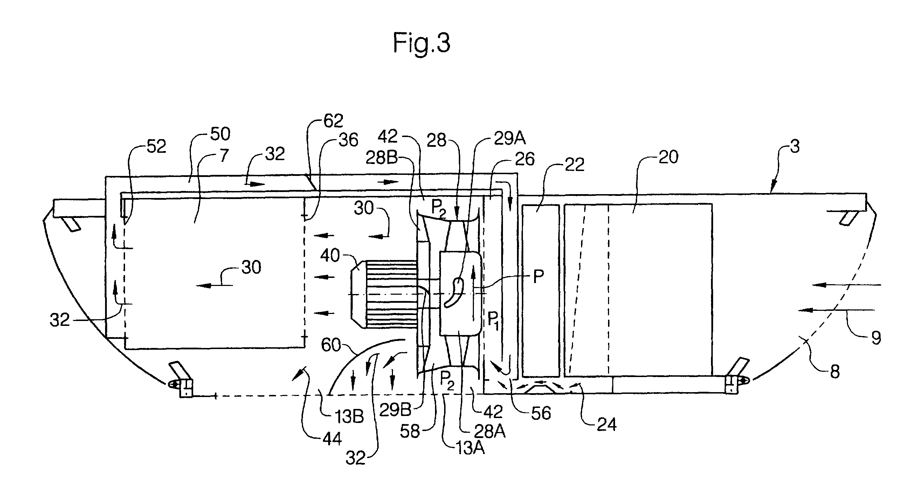

Diese Nachteile werden mit der Ausführungsform gemäß Fig. 3 überwunden, die eine völlig außendruckunabhängige Kühlung für ein elektrisches Leistungsbauteil 7 darstellt.

Wiederum ist in Fig. 3 der Unterflurbereich 3 des Fahrzeuges 1 dargestellt. Für dieselben Aggregate wie in Fig. 2 wurden der Einfachheit halber gleiche Bezugszeichen gewählt. Wie in Fig. 2 wird über einen Kühllufteinlaß 8 Umgebungsluft in den Unterflurbereich des Fahrzeuges gefördert.

Die Luft wird wie in Fig. 2 in einem Schwerkraftfilter 20 gereinigt. Die gereinigte Luft, der sogenannte Hauptluftstrom, wird durch die Flüssigkeitskühlvorrichtung 22 für die elektronischen Bauteile erwärmt und gelangt in den Raum 26, in dem ein Druck P1 herrscht. Mittels des vor dem Raum 26 angeordneten Kühlerventilators 28, der von einer Antriebsmaschine, beispielsweise Elektromotor 40 angetrieben wird, wird die Luft gefördert, die den Ventilator umgibt. Im Raum 42 direkt nach dem Kühlerventilator herrscht ein Druck P2, der stets höher als P1 ist. Der beispielhaft dargestellte Kühlerventilator 28 setzt sich zusammen aus einem in Richtung des Pfeiles P drehbar gelagerten Leitschaufelrad 28A mit Leitschaufeln 29A und einem feststehenden Nachleitschaufelrad 28B mit Nachleitschaufeln 29B. Durch eine derartige Ausbildung des Kühlerventilators wird der Drall, den der Luftstrom aufgrund des umlaufenden Leitschaufelrades erhält, eliminiert. Hierfür sind im wesentlichen die dem Leitschaufelrad nachgeordneten feststehenden Nachleitschaufeln verantwortlich. Man erhält mit einer derartigen Ausbildung eine gerichtete Luftströmung, d.h. die einzelnen Luftströme werden im Querschnitt des Ventilators gesehen mit einem gewissen geringen Versatz (z.B. 20°) im wesentlichen an Ort und Stelle gehalten, eine Vermischung der Luftströme durch den umlaufenden Kühlerventilator tritt im Querschnitt gesehen nicht ein.

Mittels des Ventilators wird Kühlluft zum zu kühlenden elektrischen Bauelement 7 gefördert. Durch geeignete Dimensionierung des Ventilators 28 kann erreicht werden, daß ein Restluftstrom 44 über den Auslaß 13B in Richtung des Gleiskörpers abgeführt wird, und nur der für die Kühlung des elektrischen Leistungsbauteiles erforderliche Anteil des durch die Kühlvorrichtung 22 bereits erwärmten Hauptluftstromes durch das elektrische Leistungsbauteil geführt wird, der wie schon in Fig. 2 als Kühlluftteilstrom 30 bezeichnet wird. Der Grund für den Austritt des Restluftstromes 44 über einen verlustarmen Auslaß 13B in Richtung des Gleiskörpers liegt anders als bei Fig. 2 darin, daß das Leistungsbauteil 7 einen Strömungswiderstand darstellt und der Ventilator so dimensioniert ist, daß der Strömungswiderstand nicht vom gesamten Luftstrom überwunden werden kann. Die Menge des für die Kühlung erforderlichen Kühlluftteilstromes wird vom Hersteller der Leistungsdrossel vorgegeben. Der Kühlluftteilstrom 30 nimmt die Wärme des elektrischen Bauelementes 7 auf. Im Gegensatz zu Fig. 2 wird der erwärmte Kühlluftteilstrom nicht an die Umgebung abgegeben sondern gelangt in einen Luftkanal 50 über dessen eingangsseitiges Ende 52, das an das elektronische Leistungsbauteil 7 anschließt. Über den Luftkanal 50 wird der erwärmte Kühlluftteilstrom 32 in den Raum 26 zwischen Kühlvorrichtung 22 und Ventilator 28 gefördert. Die Förderung des erwärmten Kühlluftteilstromes 30 durch den Luftkanal 50 wird mit Hilfe einer Zwangsströmung erreicht, die sich dadurch ergibt, daß vor dem Ventilator ein Unterdruck herrscht. Aufgrund des vor dem Ventilator herrschenden Unterdruckes ist stets sichergestellt, daß unabhängig vom Außendruck die erwärmte Kühlluft 32 über den Luftkanal 50 vom Leistungsbaubauelement 7 weggeführt wird.

Um zu verhindern, daß es zu einer Mehrfachumwälzung des erwärmten Kühlluftteilstromes 32 kommt, ist vorgesehen, das ausgangsseitige Ende 56 des Luftkanales 50 an einer Stelle im Raum 26 vorzusehen, die es erlaubt, den durch das Leistungsbauteil 7 erwärmten Luftstrom so zu führen, daß er nicht ein zweites Mal in den Kühlluftteilstrom 30 gelangt, der zur Kühlung des elektrischen Leistungsbauteiles 7 dient. Wie in Fig. 3 dargestellt, ist vorteilhafterweise die Austrittsöffnung 56 des Luftkanales 50 im Bereich des Fahrzeugbodens und benachbart zu einem weiteren Luftauslaß 13A angeordnet. Da wie zuvor beschrieben der Ventilator so ausgelegt ist, daß eine gerichtete Luftströmung erhalten wird, also eine Vermischung der Luft über den Querschnitt des Ventilators hinweg nicht auftritt, verbleibt der über Leitung 56 rückgeführte erwärmte Teil der Kühlluft im unteren Bereich des Ventilators nahe dem Luftauslaß 13A im Fahrzeugboden und wird über diesen nach außen abgegeben. Der Luftauslaß 13A ist in vorliegendem Ausführungsbeispiel benachbart zum Auslaß 13B angeordnet. Er dient sowohl zur Abfuhr des erwärmten Kühlluftteilstromes 32 als auch der Staubluft, die mit Schwebteilchen belastet ebenfalls nahe dem Fahrzeugboden geführt wird und daher wie der erwärmte Kühlluftleitstrom über Luftausstoß 13A austritt. Besonders bevorzugt ist es, wenn die Umlenkung des im unteren Bereich 58 des Ventilators geförderten erwärmten Teilluftstromes 32 und insbesondere des Staubluftstromes mittels eines Leitbleches 60 in Richtung des Luftauslasses unterstützt wird.

Selbstverständlich können die im Fahrzeug angeordneten Kühlanlagen mehrere Kühlvorrichtungen bzw. Schwerkraftfilter oder aber auch Ventilatoren umfassen, die nebeneinander angeordnet sein können. Bei einer Vielzahl beispielsweise von Ventilatoren ist es in einer fortgebildeten Ausführungsform denkbar, die den einzelnen Ventilatoren zugeordneten Luftkanäle 50 mit Klappen 62 zu versehen, um bei Ausfall eines Ventilators mittels dieser Klappen den Luftkanal sperren zu können. Dies ist zur Aufrechterhaltung einer ausreichenden Kühlung der Leistungsbauelemente in einem solchen Fall notwendig. Ist nämlich keine Rückschlagklappe vorgesehen, so wird der Kühler 22 ungleichmäßig beaufschlagt, da es zu einem Druckabfall auf der Saugseite des noch in Betrieb verbleibenden Ventilators kommt.

Mit der vorliegenden Erfindung ist es somit erstmals möglich, eine ausreichende Kühlung von im Unterflurbereich eines Fahrzeuges angeordneten Leistungsbauelementen zu erreichen, und zwar unabhängig davon, welche Außendruckverhältnisse an der Fahrzeugaußenhaut vorliegen.

## Patentansprüche

1. Unterflurkühlanlage zur Kühlung elektrischer Leistungsbauteile in einem Schienenfahrzeug mit
1.1 mindestens einem Einlaß (8) zum Eintritt eines Luftstromes (9) in den Unterflurbereich (3) des Fahrzeuges;
1.2 mindestens einem in Strömungsrichtung des Luftstromes hinter dem Einlaß (8) angeordneten Kühlerventilators (28);
1.3 mindestens einem in Strömungsrichtung des Luftstromes nach dem mindestens einen Kühlerventilator (28) angeordneten Luftauslaß (13, 13A, 13B) zum Abführen eines Luftstromes zum Gleiskörper hin, dadurch gekennzeichnet, daß die Unterflurkühlanlage des weiteren umfaßt:
1.4 mindestens einen Luftkanal (50), dessen eingangsseitiges Ende (52) dem mindestens einen Kühlerventilator gegenüber liegt zum Eintritt des nach Kühlung der Leistungsbauteile (7) erwärmten Kühlluftteilstromes (32) und einem ausgangsseitigen Ende (56), das in Strömungsrichtung des Hauptluftstromes vor dem mindestens einen Kühlventilator (28) angeordnet ist, derart, daß der vor dem Kühlerventilator herrschende Unterdruck (P1) zu einer Zwangsdurchströmung des mindestens einen Luftkanals (50) führt.

2. Unterflurkühlanlage gemäß Anspruch 1, dadurch gekennzeichnet, daß der Kühlerventilator (28) derart dimensioniert ist, daß nur ein Kühlluftteilstromes den Strömungswiderstand des zu kühlenden Leistungsbauteiles (7) überwindet, der für eine ausreichende Kühlung desselben benötigt wird, so daß nur der Kühlluftmassestrom, der dem in die Kühlanlage eintretenden Kühlluftstrom entspricht, über einen oder mehrere Luftauslasse (13, 13A, 13B) zum Gleiskörper hin abgegeben wird.

3. Unterflurkühlanlage nach einem der Ansprüche 1 bis 2, dadurch gekennzeichnet, daß in dem mindestens einen Luftkanal (50) Abschottungen (62) oder Klappen vorgesehen sind.

4. Unterflurkühlanlage gemäß Anspruch 1, 2 oder 3, dadurch gekennzeichnet, daß Leitbleche (60) vorgesehen sind, so daß der am ausgangsseitigen Ende des mindestens einen Luftkanales austretende erwärmte Kühlluftteilstrom (32) umgelenkt wird, derart, daß er über einen Restluftauslaß (13A) in die Umgebung abgeführt wird.

5. Unterflurkühlanlage nach einem der Ansprüche 1 bis 4, dadurch gekennzeichnet, daß die Unterflurkühlanlage des weiteren eine Kühlvorrichtung (22) aufweist, die der Flüssigkeitskühlung dient.

6. Unterflurkühlanlage gemäß einem der Ansprüche 1 bis 5, dadurch gekennzeichnet, daß die elektrischen Leistungsbauteile (7) im Unterflurbereich (3) elektrische Leistungsdrosseln einer Stromrichteranordnung sind.

7. Verfahren zur Kühlung elektrischer Leistungsbauteile, welche im Unterflurbereich eines Schienenfahrzeuges angeordnet sind, umfassend folgende Schritte:
7.1 Fördern von Umgebungsluft (9) in den Unterflurbereich (3) ergebend einen Luftstrom im Unterflurbereich,
7.2 Fördern eines Kühlluftteilstromes (30) mit Hilfe eines Ventilators (28) in Richtung der zu kühlenden Bauteile (7)
7.3 Kühlen der Leistungsbauteile (7) mittels des Kühlluftteilstromes (30)
7.4 Abziehen des erwärmten Kühlluftteilstromes (32) über einen Luftkanal (50) in einen Raum (26), der in Strömungsrichtung des Hauptluftstromes vor dem Ventilator (28) liegt, aufgrund des vor dem Kühlventilator herrschenden Unterdruckes und
7.5 Abführen des durch die elektrischen Leistungsbauteile erwärmten Kühlluftteilstromes (32) aus dem Raum (26) vor dem Ventilator (28) in die Umgebungsluft über einen Auslaß (13A).

8. Verwendung einer Unterflurkühlanlage gemäß einem der Ansprüche 1 bis 6 zur Durchführung eines Verfahrens gemäß Anspruch 7.

## Claims

1. Underfloor cooling facility for cooling electric power components in a rail vehicle with
1.1 at least one inlet (8) for letting an air flow (9) into the underfloor region (3) of the vehicle;
1.2 at least one cooling ventilator (28) mounted in the direction of air flow behind the inlet (8);
1.3 at least one air outlet (13, 13A, 13B) arranged in the direction of air flow after at least one cooling ventilator (28) for air outflow onto the track components, characterised in that the underfloor cooling facility also comprises
1.4 at least one ventilation duct (50), the end (52) of its inlet side being located opposite at least one cooling ventilator (28) for letting in the partial flow of cooling air (32) heated following cooling of the power components (7), and the end (56) of its outlet side being placed in the direction of the main air flow ahead of the at least one cooling ventilator (28), such that the depression (P1) prevailing upstream of the cooling ventilator compels air to flow through the at least one ventilation duct (50).

2. Underfloor cooling facility according to claim 1, characterised in that the cooling ventilator (28) is dimensioned such that only a partial flow of cooling air overcomes the flow resistance of the power component (7) to be cooled, which is required for the adequate cooling thereof, so that only the cooling air mass flow, which corresponds to the cooling air flow entering the cooling facility, is supplied via one or more air outlets (13, 13A, 13B) to the track components.

3. Underfloor cooling facility according to one of claims 1 to 2, characterised in that in the at least one ventilation duct (50) screens (62) or flaps are provided.

4. Underfloor cooling facility according to claim 1, 2 or 3, characterised in that deflector plates (60) are provided so that the heated partial flow of cooling air (32) exiting the outlet side of the at least one ventilation duct is deflected so that it is removed via an residual air outlet (13A) into the environment.

5. Underfloor cooling facility according to one of claims 1 to 4, characterised in that the underfloor cooling facility also comprises a cooling device (22) which is used for cooling the liquid.

6. Underfloor cooling facility according to one of claims 1 to 5, characterised in that the electric power components (7) in the underfloor region (3) are electric power restrictors of a converter device.

7. Process for cooling electric power components which are arranged in the underfloor region of a railway vehicle comprising the following stages:
7.1 conveying air (9) from the environment to the underfloor region (3) producing an air flow in the underfloor region,
7.2 conveying a partial flow of cooling air (30) by means of a ventilator (28) in the direction of the components (7) to be cooled,
7.3 cooling the power components (7) by means of the partial flow of cooling air (30)
7.4 removing the heated partial flow of cooling air (32) via a ventilation duct (50) into a chamber (26) which lies in flow direction of the main air flow before the ventilator (28), due to the depression prevailing upstream of the cooling duct and
7.5 removing the partial flow of cooling air flow (32) heated by the electric power components from the chamber (26) before the ventilator (28) into the environment via an outlet (13A).

8. Use of an underfloor cooling facility according to one of claims 1 to 6 for performing a process according to claim 7.

## Revendications

1. Installation de refroidissement sous plancher pour le refroidissement d'équipements électriques de puissance dans un véhicule sur rails, avec :
- au moins une admission (8) pour l'entrée d'un courant d'air (9) dans la zone sous plancher (3) du véhicule ;
- au moins un ventilateur refroidisseur (28) disposé dans le sens de l'écoulement du courant d'air en aval de l'admission (8) ;
- au moins une sortie d'air (13, 13A, 13B) disposée dans le sens de l'écoulement du courant d'air en aval du - au moins - un ventilateur refroidisseur (28) pour évacuer un courant d'air vers le corps de voie, caractérisée en ce que l'installation de refroidissement sous plancher comporte en outre :
- au moins un canal d'air (50) dont l'extrémité côté entrée (52) est située à l'opposé du - au moins - un ventilateur refroidisseur, pour l'entrée du courant partiel d'air de refroidissement (32) réchauffé après refroidissement des composants de puissance (7) et dont une extrémité côté sortie (56) est disposée dans le sens de l'écoulement du courant d'air principal devant le - au moins - un ventilateur refroidisseur (28), de sorte que la dépression (P1) régnant devant le ventilateur refroidisseur conduise à une circulation forcée dans ledit - au moins - un canal d'air (50).

2. Installation de refroidissement sous plancher suivant la revendication 1, caractérisée en ce que le ventilateur refroidisseur (28) est dimensionné de façon à ce que seulement un courant partiel d'air de refroidissement surmonte la résistance à l'écoulement dans le composant de puissance (7) à refroidir, courant qui est requis pour un refroidissement suffisant dudit composant, de sorte que seul le courant de masse d'air de refroidissement qui correspond au courant d'air de refroidissement entrant dans l'installation de refroidissement soit déchargé vers la voie via une ou plusieurs sorties d'air (13, 13A, 13B).

3. Installation de refroidissement sous plancher suivant l'une des revendications 1 ou 2, caractérisée en ce que des cloisonnements (62) ou clapets sont prévus dans le - au moins - un canal d'air (50).

4. Installation de refroidissement sous plancher suivant la revendication 1, 2 ou 3, caractérisée en ce que des tôles de guidage (60) sont prévues, de sorte que le courant partiel d'air de refroidissement (32) réchauffé sortant à l'extrémité du côté sortie dudit-au moins - un canal d'air soit dévié, de façon à ce qu'il soit évacué dans l'environnement via une sortie d'air résiduel (13A).

5. Installation de refroidissement sous plancher suivant l'une des revendications 1 à 4, caractérisée en ce qu'elle présente en outre un dispositif refroidisseur (22) qui sert au refroidissement de liquide.

6. Installation de refroidissement sous plancher suivant l'une des revendications 1 à 5, caractérisée en ce que les composants électriques (7) de puissance dans la zone sous plancher (3) sont des bobines de puissance d'un dispositif convertisseur.

7. Procédé de refroidissement de composants d'équipements électriques de puissance qui sont disposés dans la zone sous plancher d'un véhicule sur rails, comportant les étapes suivantes :
- alimentation en air ambiant (9) de la zone sous plancher (3) produisant un courant d'air dans la zone sous plancher,
- création d'un courant partiel d'air de refroidissement (30) à l'aide d'un ventilateur (28) en direction des composants à refroidir (7),
- refroidissement des composants de puissance (7) au moyen du courant partiel d'air de refroidissement (30),
- extraction du courant partiel d'air de refroidissement réchauffé (32) via un canal d'air (50) dans un espace (26) qui est situé dans le sens de l'écoulement du courant d'air principal devant le ventilateur (28), en raison de la dépression régnant devant le ventilateur refroidisseur, et
- évacuation du courant partiel d'air de refroidissement (32) réchauffé par les composants électriques de puissance, de l'espace (26) en amont du ventilateur (28) dans l'atmosphère via une sortie (13A).

8. Utilisation d'une installation de refroidissement sous plancher suivant l'une des revendications 1 à 6, pour la mise en oeuvre d'un procédé suivant la revendication 7.
